# EUROPÄISCHE PATENTSCHRIFT

(11) **EP 3 371 657 B1**
(45) Veröffentlichungstag und Bekanntmachung des Hinweises auf die Patenterteilung: **29.09.2021**
(21) Anmeldenummer: 16794540.1
(22) Anmeldetag: 25.10.2016
(51) Int. Cl.: G03F 7/20, G01N 21/47, G01N 21/95

(54) **VERFAHREN UND VORRICHTUNG ZUR CHARAKTERISIERUNG EINES DURCH WENIGSTENS EINEN LITHOGRAPHIESCHRITT STRUKTURIERTEN WAFERS**
METHOD AND DEVICE FOR CHARACTERIZING A WAFER PATTERNED USING AT LEAST ONE LITHOGRAPHY STEP
PROCÉDÉ ET DISPOSITIF DE CARACTÉRISATION D'UNE TRANCHE STRUCTURÉE PAR AU MOINS UNE ÉTAPE DE LITHOGRAPHIE

(30) Priorität: 05.11.2015 DE 102015221772; 28.07.2016 DE 102016213925
(43) Veröffentlichungstag der Anmeldung: 12.09.2018
(60) Teilanmeldung: 21192882.5
(73) Patentinhaber: Carl Zeiss SMT GmbH, 73447 Oberkochen (DE)
(72) Erfinder: STIEPAN, Hans-Michael, 73430 Aalen (DE); ZOTT, Andy, 89547 Gerstetten (DE); MANTZ, Ulrich, 89601 Schelklingen (DE)
(74) Vertreter: Frank, Hartmut
(86) Internationale Anmeldenummer: PCT/EP2016/075701
(87) Internationale Veröffentlichungsnummer: WO 2017/076702

(56) Entgegenhaltungen:
- US-A1- 2008 117 434
- US-A1- 2013 116 978

## Beschreibung

### HINTERGRUND DER ERFINDUNG

### Gebiet der Erfindung

Die Erfindung betrifft ein Verfahren und eine Vorrichtung zur Charakterisierung eines durch wenigstens einen Lithographieschritt strukturierten Wafers.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

Hierbei besteht in der Praxis der Bedarf, für den strukturierten Wafer charakteristische Parameter zu kontrollieren, z.B. den CD-Wert oder die Schichtdicke. Insbesondere bei sogenannten "Multi-Patterning"-Verfahren zur Unterschreitung der Auflösungsgrenze des optischen Systems mit in mehreren Lithographieschritten auf dem Wafer erzeugten Strukturen muss eine große Zahl von Prozessparametern kontrolliert werden. Von besonderer Bedeutung ist hier oft das sogenannte Overlay.

Bei der Bestimmung solcher Parameter ist es u.a. bekannt, Hilfsstrukturen in Form geeigneter Markerbereiche insbesondere in Randbereichen der jeweils hergestellten Waferelemente zu erzeugen, um anhand dieser Hilfsstrukturen eine beugungsbasierte Bestimmung der jeweiligen relevanten Parameter in einem scatterometrischen Aufbau durchzuführen.

Ein hierbei in der Praxis auftretendes Problem ist, dass die anhand solcher Hilfsstrukturen ermittelten Parameterwerte nicht notwendigerweise das tatsächliche Verhalten der auf dem Wafer enthaltenen Nutzstrukturen repräsentieren, was z.B. auf einer unzureichenden Korrelation zwischen Nutz- und Hilfsstruktur und/oder einem großen Abstand zwischen diesen zurückzuführen sein kann. Ein weiteres in der Praxis auftretendes Problem resultiert mitunter aus der vergleichsweise hohen Anzahl benötigter Hilfsstrukturen, deren sukzessive Auswertung mit einer signifikanten Beeinträchtigung des Durchsatzes des Lithographieverfahrens einherginge.

Des Weiteren stellt die Ermittlung einer Mehrzahl relevanter Parameter innerhalb einer gegebenenfalls komplex aufgebauten Nutzstruktur auf einem Wafer auch insoweit eine anspruchsvolle Herausforderung dar, als die betreffenden Parameter unter Umständen nur schwer simultan in einem einzigen Messaufbau bestimmt werden können. Dies ist dann der Fall, wenn diese Parameter in dem Sinne linear abhängig sind, dass gewisse Kombinationen dieser Werte im Kern (d.h. Eigenvektoren zum Eigenwert 0) der das Problem beschreibenden Kovarianzmatrix liegen. Oft tritt dieser Fall bei einer in einer beugungsbasierten Bestimmung erfassten Abweichung zwischen gemessenen und simulierten Werten auf, so dass nicht eindeutig entschieden werden kann, welche Parametervariation für diese Abweichung ursächlich ist.

Zum Stand der Technik wird lediglich beispielhaft auf US 2013/116978 A1, US 2008/117434 A1, US 2006/0274325 A1, US 8,339,595 B2, US 8,670,118 B2 und US 2012/0224176 A1, US 2003/0219153 A1, US 2009/0037134 A1 und US 7,916,286 B2 verwiesen.

### ZUSAMMENFASSUNG DER ERFINDUNG

Vor dem obigen Hintergrund ist es eine Aufgabe der vorliegenden Erfindung, ein Verfahren und eine Vorrichtung zur Charakterisierung eines durch wenigstens einen Lithographieschritt strukturierten Wafers bereitzustellen, welche die möglichst rasche und zuverlässige Ermittlung von einer oder mehreren für den strukturierten Wafer charakteristischen Kenngrößen unter möglichst geringer Beeinträchtigung des Durchsatzes der Projektionsbelichtungsanlage ermöglichen.

Diese Aufgabe wird durch das Verfahren bzw. die Vorrichtung gemäß den Merkmalen der unabhängigen Patentansprüche 1, 5 und 9 gelöst.

Gemäß einem Aspekt wird bei einem erfindungsgemäßen Verfahren zur Charakterisierung eines durch wenigstens einen Lithographieschritt strukturierten Wafers eine Mehrzahl von für den strukturierten Wafer charakteristischen Parametern auf Basis von Messungen der Intensität elektromagnetischer Strahlung nach deren Beugung an dem strukturierten Wafer ermittelt, wobei diese Intensitätsmessungen für wenigstens eine Nutzstruktur und wenigstens eine Hilfsstruktur durchgeführt werden, und wobei eine Ermittlung der Parameter basierend auf bei den Intensitätsmessungen für jeweils unterschiedliche Kombinationen aus Wellenlänge, Polarisation und/oder Beugungsordnung gemessenen Intensitätswerten sowie entsprechend berechneten Intensitätswerten unter Anwendung einer mathematischen Optimierungsmethode erfolgt.

Die Ermittlung der für den strukturierten Wafer charakteristischen Parameter weist folgende Schritte auf:
- Ermitteln von Parametern eines ersten Parametersatzes auf Basis der für die wenigstens eine Hilfsstruktur erhaltenen Intensitätswerte; und
- Ermitteln von Parametern eines zweiten Parametersatzes unter Berücksichtigung der ermittelten Parameter des ersten Parametersatzes.

Der Erfindung liegt insbesondere das Konzept zugrunde, bei den jeweils zu ermittelnden, für einen strukturierten Wafer charakteristischen Parametern zwischen zwei unterschiedlichen Parametersätzen hinsichtlich der Auswertung der in einem scatterometrischen Aufbau durchgeführten Intensitätsmessungen insoweit zu unterscheiden, als in einer zweistufigen Auswertung zunächst nur die an einer oder mehreren Hilfsstrukturen durchgeführten Intensitätsmessungen ausgewertet und zur Bestimmung eines ersten Parametersatzes herangezogen werden. Die in solcher Weise anhand der wenigstens einen Hilfsstruktur ausgewerteten Parameter des ersten Parametersatzes werden dann anschließend für die verbleibenden Parameter des zweiten Parametersatzes (ggf. unter Berücksichtigung geeigneter Unsicherheiten bzw. eines jeweils vorgegebenen Variationsintervalls) entsprechend vorgegeben, so dass im Ergebnis auch bei einer vergleichsweise komplexen Waferstrukturierung sämtliche Parameter - sowohl die des ersten wie auch die des zweiten Parametersatzes - ermittelt werden können.

Dadurch, dass erfindungsgemäß in der vorstehend beschriebenen zweistufigen Auswertung zunächst nur bestimmte Parameter anhand einer oder mehrerer geeigneter Hilfsstrukturen berechnet werden, ermöglicht es die Erfindung, zwischen anhand der Messung von Hilfsstrukturen gut bestimmbaren Parametern und anderen - etwa infolge einer bestehenden Abhängigkeit von diesen Parametern - vergleichsweise schwieriger zu bestimmenden Parametern zu unterscheiden und die aus der ersten Stufe der o.g. Auswertung gewonnenen Informationen bei der nachfolgenden Ermittlung der jeweiligen Parameter des zweiten Parametersatzes (bei denen es sich typischerweise um die vergleichsweise schwieriger zu bestimmenden Parameter handelt) zu nutzen. Beispielsweise können dem ersten Parametersatz solche Parameter zugeordnet werden, welche über den Wafer hinweg vergleichsweise wenig variieren und/oder deren Eigenschaften sich bei Bestimmung an den Hilfsstrukturen von denjenigen bei Bestimmung an den Nutzstrukturen nur vergleichsweise wenig unterscheiden.

Ausgehend von diesem Konzept beinhaltet die Erfindung das weitere Prinzip, die betreffenden Hilfsstrukturen auf dem Wafer von vorneherein (d.h. noch vor Durchführung der o.g. Intensitätsmessungen) gezielt in solcher Weise auszugestalten, dass diese Hilfsstrukturen gerade für die Bestimmung der betreffenden Parameter des ersten Parametersatzes geeignet bzw. optimiert sind. Diese gezielte Ausgestaltung der Hilfsstrukturen kann jeweils auf Basis einer Sensitivitätsanalyse erfolgen, bei welcher die Sensitivität unterschiedlicher Hilfsstrukturen für eine beugungsbasierte Messung jeweils eines der Parameter des ersten Parametersatzes bewertet wird. Hierzu wird auf Thomas A. Germer et al.: "Developing an uncertainty analysis for optical scatterometry Metrology, Inspection, and Process Control for Microlithography XXIII, J.A. Allgair, Ed., Proc. SPIE 7272, (2009) verwiesen.

Gemäß der im unabhängigen Anspruch 1 zitierten Ausführungsform werden die Intensitätsmessungen für die wenigstens eine Nutzstruktur und die wenigstens eine Hilfsstruktur für jeweils eine Kombination aus Wellenlänge, Polarisation und/oder Beugungsordnung simultan durchgeführt. Mit anderen Worten erfolgt die erfindungsgemäße beugungsbasierte Messung für einen bestimmten Messzeitpunkt bzw. Messschritt nicht nur für einen Bereich auf dem Wafer, sondern es werden simultan mehrere Bereiche bzw. Strukturen auf dem Wafer vermessen, so dass auch eine zur Charakterisierung komplexer Nutzstrukturen erforderliche Vermessung einer Vielzahl von Nutz- und/oder Hilfsstrukturen ohne signifikante Beeinträchtigung des Durchsatzes der Projektionsbelichtungsanlage ermöglicht wird.

Gemäß der im unabhängigen Anspruch 5 zitierten Ausführungsform werden die Intensitätsmessungen für eine Mehrzahl von Hilfsstrukturen durchgeführt, wobei diese Durchführung für jeweils eine Kombination aus Wellenlänge, Polarisation und/oder Beugungsordnung simultan erfolgt. Hierbei kann das Ermitteln von Parametern des ersten Parametersatzes auf Basis der für die Hilfsstrukturen erhaltenen Intensitätswerte jeweils einen Vergleich dieser Intensitätswerte mit in wenigstens einer Datenbank gespeicherten Intensitätswerten umfassen, wobei in dieser Datenbank mehreren Hilfsstrukturen jeweils ein zugehöriges Intensitätsspektrum zugeordnet ist. Auf Basis dieses Vergleichs mit in der wenigstens einen Datenbank gespeicherten Intensitätswerten kann eine Lokalisierung von zur Bestimmung eines Parameters jeweils geeigneten Strukturen auf dem Wafer erfolgen.

Gemäß diesem Aspekt beinhaltet die Erfindung das weitere Konzept, bereits anhand der durchgeführten Intensitätsmessungen zu entscheiden, wo auf dem Wafer die jeweils zur Auswertung bestimmter Parameter relevanten Strukturen angeordnet sind, so dass eine entsprechende vorherige Eingabe dieser Information entbehrlich ist. Vielmehr kann erfindungsgemäß direkt eine scatterometrische Aufnahme eines größeren Feldes auf dem Wafer erfolgen, da die betreffende Information über die Position der auszumessenden, relevanten Strukturen aus den gemessenen Daten und deren Vergleich mit einer vorab bereitgestellten Datenbank selbst geliefert wird.

Mit anderen Worten kann erfindungsgemäß zunächst eine Datenbank mit einzelnen typischen Strukturen und jeweils zugeordneten Intensitätsspektren bereitgestellt werden, welche für jede der betreffenden Strukturen ein charakteristisches Intensitätsspektrum enthält. Ein im Rahmen der eigentlichen beugungsbasierten Intensitätsmessung dann erhaltenes Messergebnis, welches mit einem der betreffenden, in der Datenbank enthaltenen Referenzspektren hinreichend (d.h. innerhalb vorgebbarer Fehlergrenzen) gut übereinstimmt, erlaubt sodann den Rückschluss, dass die dem Referenzspektrum in der Datenbank zugeordnete Struktur in dem betreffenden Waferbereich vorliegt und für die jeweils geeignete Parameterbestimmung herangezogen werden kann.

Das vorstehend beschriebene Konzept der datenbankbasierten Lokalisierung von Hilfsstrukturen auf dem Wafer ist auch unabhängig von dem zuvor beschriebenen Ansatz einer zweistufigen Auswertung unter Unterscheidung in Parameter des ersten und des zweiten Parametersatzes vorteilhaft.

Gemäß einer Ausführungsform umfassen die für den strukturierten Wafer charakteristischen Parameter wenigstens einen Parameter aus der Gruppe CD-Wert, Ätztiefe und Überdeckungsgenauigkeit (Overlay) von zwei in unterschiedlichen Lithographieschritten erzeugten Strukturen.

Die Erfindung betrifft weiter eine Vorrichtung zur Charakterisierung eines durch wenigstens einen Lithographieschritt strukturierten Wafers, wobei die Vorrichtung dazu konfiguriert ist, ein Verfahren mit den vorstehend beschriebenen Merkmalen durchzuführen. Zu Vorteilen sowie vorteilhaften Ausgestaltungen der Vorrichtung wird auf die vorstehenden Ausführungen im Zusammenhang mit dem erfindungsgemäßen Verfahren Bezug genommen.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

Die Reichweite der Erfindung wird durch die Ansprüche definiert.

### KURZE BESCHREIBUNG DER ZEICHNUNGEN

Es zeigen:
- Figur 1: eine schematische Darstellung des möglichen Aufbaus einer Messanordnung bzw. Vorrichtung zur Durchführung des erfindungsgemäßen Verfahrens;
- Figur 2: ein Flussdiagramm zur Erläuterung des möglichen Ablaufs eines erfindungsgemäßen Verfahrens in einer Ausführungsform;
- Figur 3-7: schematische Darstellungen zur Erläuterung unterschiedlicher Ausführungsformen der Erfindung;
- Figur 8: eine schematische Darstellung zur Erläuterung eines der vorliegenden Erfindung zugrundeliegenden Problems;
- Figur 9: ein Flussdiagramm zur Erläuterung des möglichen Ablaufs eines Verfahrens, welches nicht Teil der Erfindung ist; und

- Figur 10: eine schematische Darstellungen beispielhafter möglicher Spektren, welche in dem Verfahren gemäß der Figur 9 für Spots mit gleicher Struktur auf unterschiedlichen Wafern bzw. Chips im Falle geringfügiger Prozessvariationen bei der Strukturierung erhalten werden.

### DETAILLIERTE BESCHREIBUNG

### BEVORZUGTER AUSFÜHRUNGSFORMEN

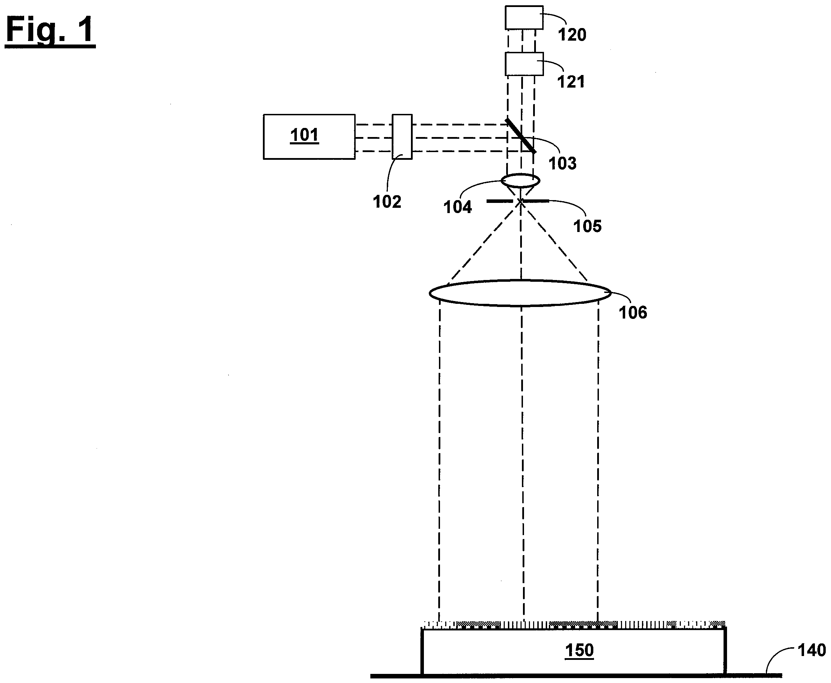

Fig. 1 zeigt zunächst in schematischer Darstellung den möglichen Aufbau einer Messanordnung bzw. Vorrichtung zur Durchführung des erfindungsgemäßen Verfahrens.

Die Messanordnung von Fig. 1 ist als Scatterometer ausgestaltet und weist eine Lichtquelle 101 auf, bei der es sich z.B. um eine stimmbare Lichtquelle zur Erzeugung eines Wellenlängenspektrums (beispielsweise im Wellenlängenbereich von 300nm bis 800nm) handeln kann. Das Licht der Lichtquelle 101 trifft über einen (ggf. zur Einstellung von linear polarisiertem Licht unterschiedlicher Polarisationsrichtungen austauschbaren) Polarisator 102, einen Strahlteiler 103, eine Linse 104, eine Blende 105 und eine weitere Linse 106 auf einen auf einer Waferebene bzw. Waferstage 140 angeordneten Wafer 150 bzw. die auf diesem Wafer 150 bereits lithographisch erzeugten (und in Fig. 1 lediglich schematisch angedeuteten) Strukturen.

Nach Beugung an diesen Strukturen gelangt das Licht gemäß Fig. 1 in der 0. Beugungsordnung zurück über einen Analysator 121 auf einen Detektor (Kamera) 120. Unter Einsatz unterschiedlicher Spektralfilter bzw. Polarisatoren 102 kann die Intensitätsmessung mit dem Detektor 120 für eine Vielzahl unterschiedlicher Wellenlängen bzw. Polarisationszustände erfolgen. In weiteren Ausführungsformen können zusätzlich oder alternativ zu der 0. Beugungsordnung auch andere Beugungsordnungen berücksichtigt werden.

Auf Basis der mit dem Detektor 120 gemessenen Intensitätswerte lässt sich durch Vergleich (insbesondere Differenzbildung) grundsätzlich modellbasiert in für sich bekannter Weise eine Bestimmung bzw. Kontrolle der relativen Position von in unterschiedlichen Lithographieschritten auf dem Wafer 150 erzeugten Strukturen (z.B. hierzu vorgesehenen Markerstrukturen) vornehmen.

Dabei werden die für unterschiedliche Kombinationen aus Wellenlänge, Polarisation und Beugungsordnung erhaltenen Messwerte (z.B. 2*2*10=40 Messwerte bei Messung für zwei unterschiedliche Polarisationszustände, zwei Beugungsordnungen und zehn unterschiedliche Wellenlängen) jeweils an ein durch Lösung der Maxwell-Gleichungen erzeugtes Modell angefittet, wobei z.B. die Methode der kleinsten quadratischen Abweichung angewendet werden kann. Hierbei kann angedeutet gegebenenfalls auch eine Iteration durchgeführt werden. Dabei erfolgt die vorstehend beschriebene Bestimmung der jeweils einem strukturierten Waferbereich zugeordneten Werte der relevanten Parameter (z.B. Overlay-Wertes, CD-Wert, etc.) zu jedem Messzeitpunkt bzw. in jedem Messschritt nicht nur für einen einzigen strukturierten Waferbereich, sondern simultan für eine Mehrzahl von Waferbereichen, d.h. zur Ermittlung einer Mehrzahl von Werten der jeweiligen Parameter, wobei dieser Werte eines Parameters jeweils einem der Mehrzahl von simultan vermessenden Bereichen zugeordnet ist. Demzufolge werden erfindungsgemäß in jedem Messschritt bzw. zu jedem Messzeitpunkt nicht nur einzelne Spots (zur Bestimmung jeweils nur eines einzigen Overlay-Wertes) vermessen, sondern es wird ein Feld auf den betreffenden Detektor (Kamera) 120 abgebildet. Das erfindungsgemäß abgebildete Feld kann hierbei eine Größe von typischerweise mehreren mm² aufweisen. Hierbei kann lediglich beispielhaft der simultan aufgenommene Gesamtbereich auf dem Wafer der Größe eines typischen Waferelements bzw. Chips ("Die") entsprechen und einen Wert von z.B. 26mm*33mm besitzen.

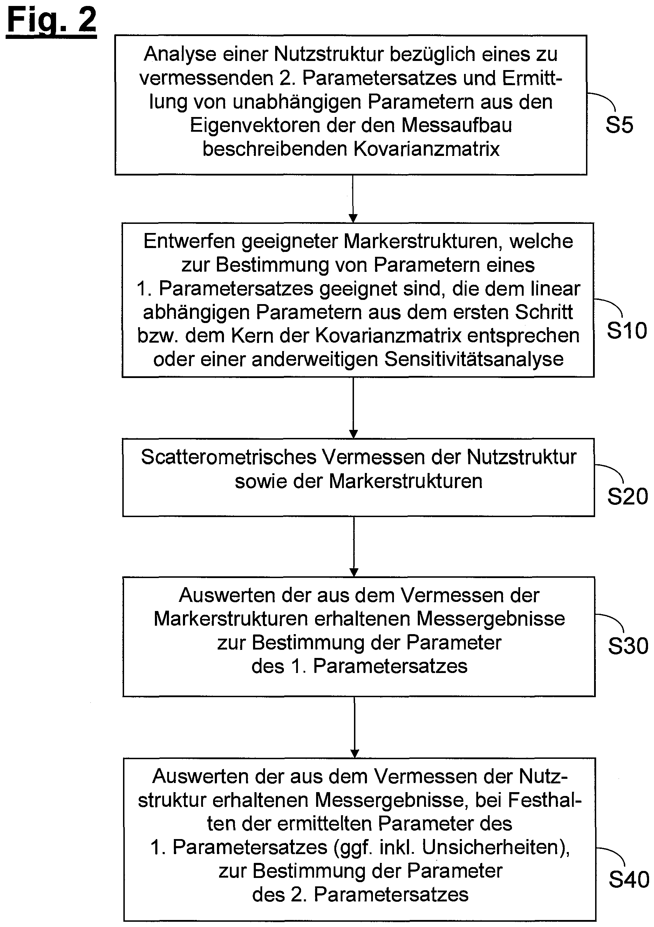

Im Folgenden wird eine mögliche Ausführungsform des erfindungsgemäßen Verfahrens unter Bezugnahme auf Fig. 2 bis 4 beschrieben.

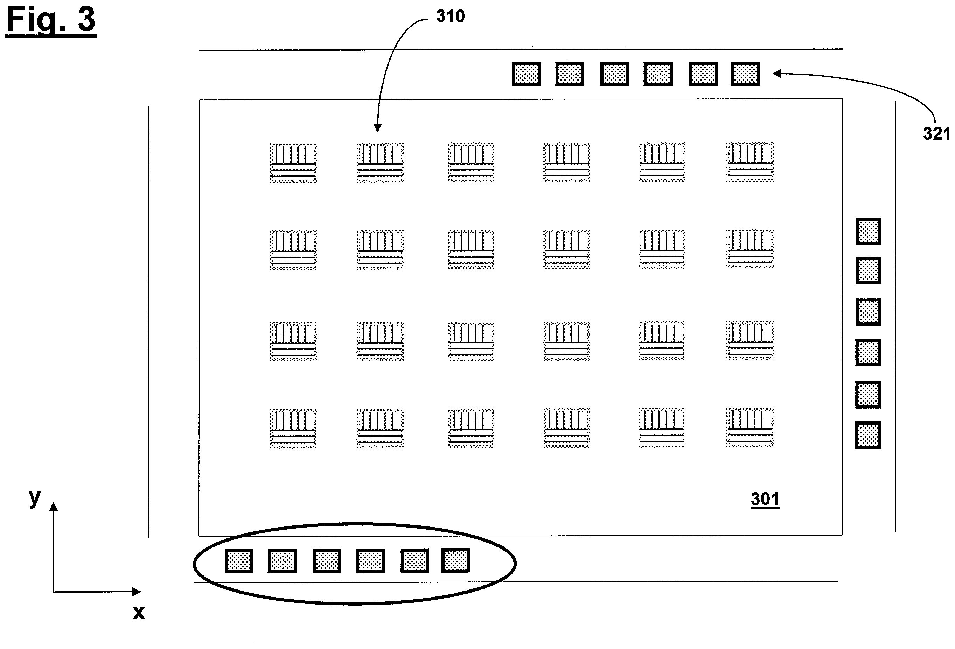

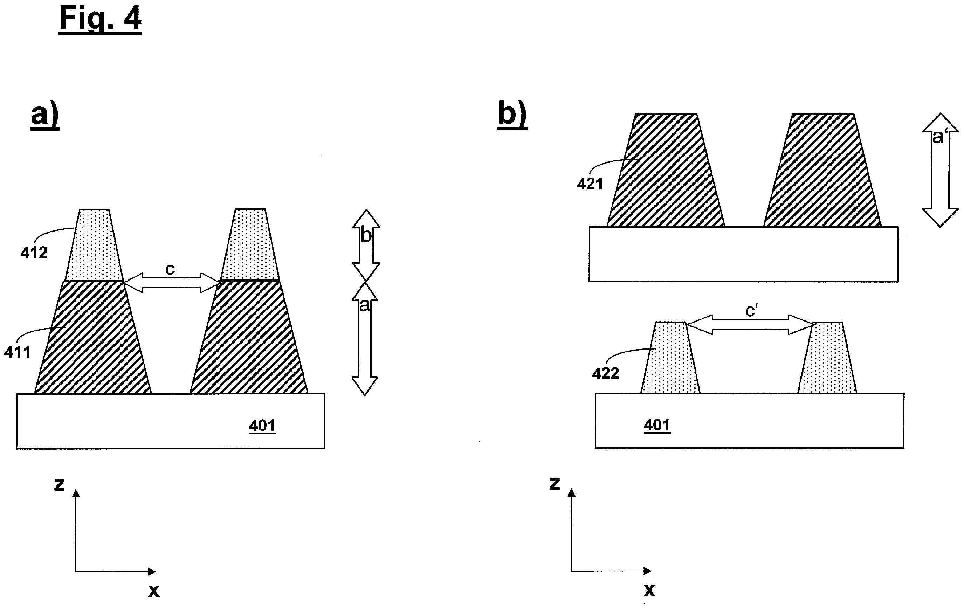

Fig. 3 zeigt in lediglich schematischer und stark vereinfachter Darstellung einen Wafer 301 in Draufsicht, wobei sich auf dem Wafer 301 sowohl diverse Nutzstrukturen 310 als auch Hilfsstrukturen 321 befinden, wobei die zuletzt genannten Hilfsstrukturen 321 typischerweise außerhalb der Nutzstrukturen bzw. zwischen den jeweils hergestellten Chips befindlichen "scribe lines" (d.h. Bruchlinien bzw. -bereiche des Wafers) angeordnet sind. In Fig. 4 sind lediglich schematisch mögliche Parameter zur Charakterisierung eines strukturierten Wafers veranschaulicht, wobei "a" und "b" jeweils Schichtdicken zweier in unterschiedlichen Lithographieschritten über einem Substrat 401 aufgebrachter Schichten 411 bzw. 412 bezeichnen, und wobei "c" den Abstand der hierdurch auf dem Substrat 401 erzeugten Schichtbereiche am Übergang zwischen den Schichten 411, 412 bezeichnet.

Während nun die gleichzeitige Ermittlung sämtlicher Parameter a, b und c in einem derart strukturierten Wafer dadurch erschwert wird, dass diese Parameter a, b und c unter Umständen nicht voneinander unabhängig sind, kann gleichwohl zunächst eine separate Bestimmung sowohl des Parameters a als auch des Parameters c anhand geeigneter Hilfsstrukturen gemäß Fig. 4b erfolgen.

Erfindungsgemäß erfolgt daher in einer zweistufigen Auswertung zunächst die Bestimmung der Parameter a' und c', die - wie aufgrund vorheriger Analysen bekannt - direkt mit a bzw. c korreliert sind, auf Basis der für die betreffenden Hilfsstrukturen erhaltenen Intensitätswerte und unter Anwendung des vorstehend beschriebenen Optimierungsverfahrens. Nach Ermittlung der Parameter a' und c' (entsprechend einem ersten Parametersatz) werden nun die hierbei erhaltenen Werte für a und c (gegebenenfalls mit jeweils einem geeigneten möglichen Variationsintervall) einem zweiten Auswerteschritt zur Ermittlung des Parameters b (entsprechend dem zweiten Parametersatz) vorgegeben, welcher nun ebenfalls anhand der vorstehend beschriebenen mathematischen Optimierungsmethode und gemäß Auswertung der eigentlichen Nutzstruktur gemäß Fig. 4a ermittelt werden kann.

Wie vorstehend anhand von Fig. 4b beschrieben wurde, sind die für die Ermittlung des ersten Parametersatzes herangezogenen Hilfsstrukturen vorzugsweise gerade gezielt dahingehend optimiert, dass diese jeweils zur Bestimmung eines oder mehrerer Parameter geeignet sind, was anhand einer Sensitivitätsanalyse erfolgen kann. Mit anderen Worten werden die in Fig. 3 gezeigten Hilfsstrukturen 321 vorzugsweise von vorneherein auf dem Wafer 301 derart ausgestaltet, dass sie jeweils auf die Messung bestimmter Parameter optimiert sind.

Fig. 2 stellt den Ablauf des vorstehend beschriebenen Verfahrens in einem Flussdiagramm dar.

In einem ersten Schritt S5 erfolgt eine Analyse der zu vermessenden Struktur bzgl. eines zweiten Parametersatzes dahingehend, welche Parameter direkt bestimmbar sind, bzw. welche weiteren Parameter über ggf. zu erzeugende Hilfsstrukturen zu erfolgen hat.

Demnach erfolgt in einem weiteren Schritt S10 das geeignete Design der Hilfs- bzw. Markerstrukturen, die zur Bestimmung der Parameter eines ersten Parametersatzes geeignet sind, welche so gewählt werden, dass damit die nicht direkt zu bestimmenden Parameter des zweiten Parametersatzes bestimmt werden können, wiederum basierend auf einer Sensitivitätsanalyse.

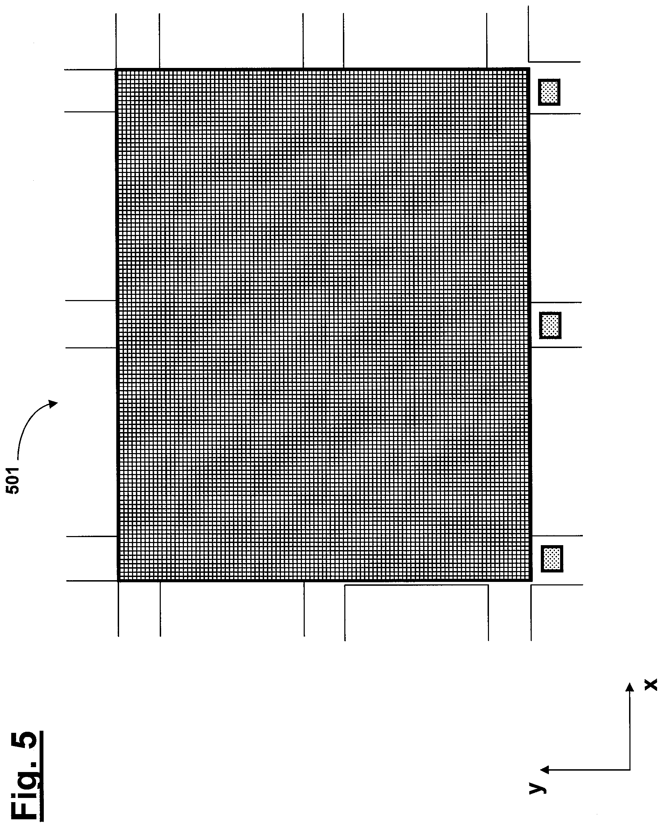

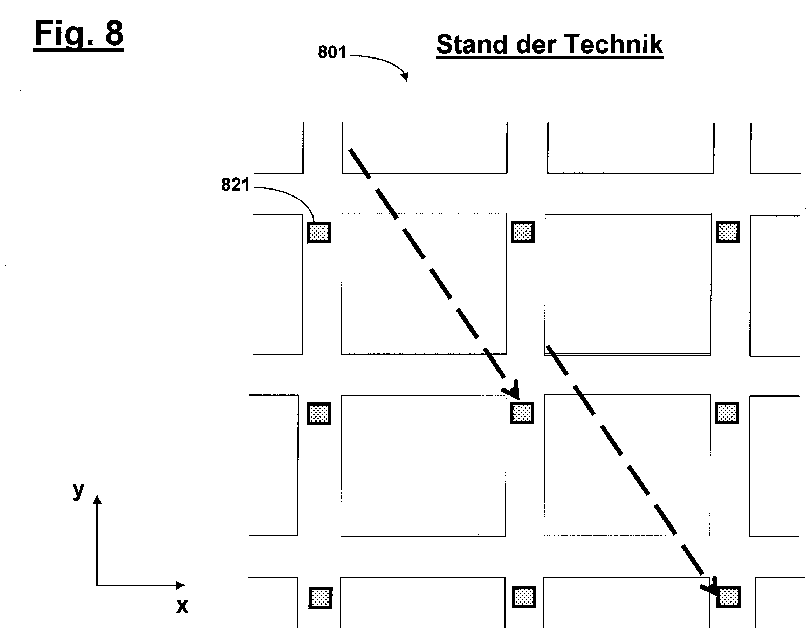

Anschließend erfolgt in einem Schritt S20 die beugungsbasierte Vermessung der auf dem Wafer erzeugten Nutzstrukturen sowie der o.g. Hilfsstrukturen. Diese Intensitätsmessungen selbst werden gemäß der Erfindung sowohl für die Nutz- als auch die Hilfsstrukturen vorzugsweise für jede Kombination aus Wellenlänge, Polarisation und Beugungsordnung simultan durchgeführt. Mit anderen Worten erfolgt anstelle einer sukzessiven Beleuchtung und beugungsbasierten Vermessung einzelner Hilfsstrukturen 821 gemäß Fig. 8 die Beleuchtung eines ganzen Feldes 501 gemäß Fig. 5, wobei dieses Feld lediglich beispielhaft eine Größe von mehreren mm², z.B. 30mm*40mm aufweisen kann. Demzufolge werden erfindungsgemäß auch etwaige Alignment-Schritte vermieden, welche bei der vorstehend genannten sukzessiven Beleuchtung und beugungsbasierten Vermessung einzelner Hilfsstrukturen erforderlich sind, um die Messposition abhängig von der jeweiligen Position der sequentiell angefahrenen Hilfsstrukturen präzise einzustellen.

Hierbei entsprechen einzelne (z.B. gemäß Fig. 5 durch Aufteilung in eine Vielzahl von einzelnen Messkanälen erhaltene) Waferbereiche jeweils einem Detektorbereich (mit umfassend einen oder mehrere Kamerapixel auf dem Detektor).

Die erhaltenen Intensitätswerte werden dann wie vorstehend beschrieben zweistufig ausgewertet. Zunächst erfolgt im Schritt S30 anhand der an den Hilfsstrukturen erhaltenen Messergebnisse die Bestimmung eines ersten Parametersatzes. Im Schritt S40 erfolgt dann erst unter Nutzung der Ergebnisse aus Schritt S30 (nämlich unter Vorgabe der für die Parameter des ersten Parametersatzes erhaltenen Werte, ggf. unter Zulassung von Abweichungen innerhalb eines Variationsintervalls) die Bestimmung der Parameter des zweiten Parametersatzes.

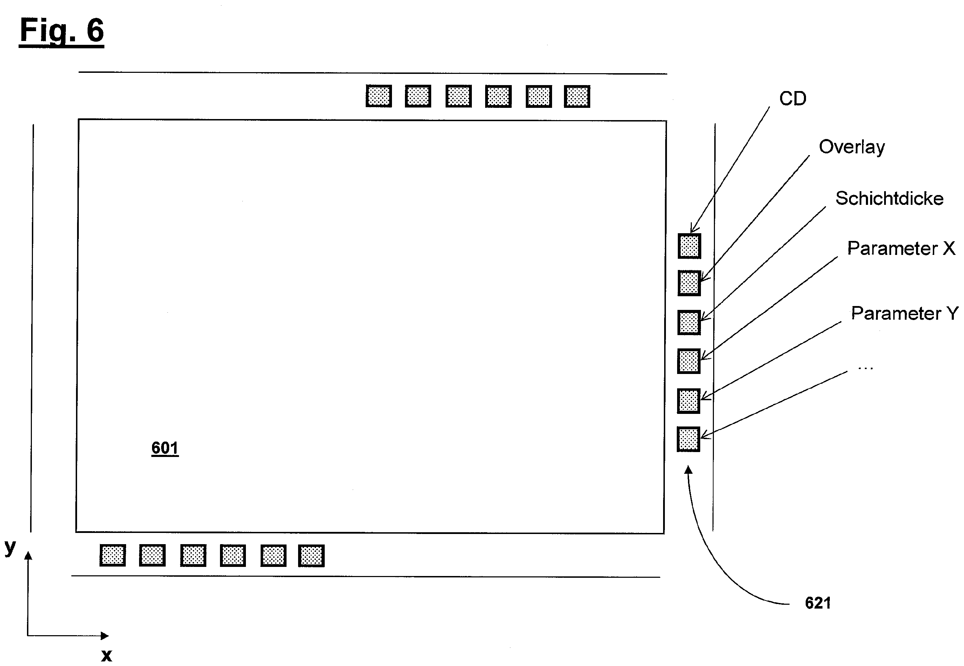

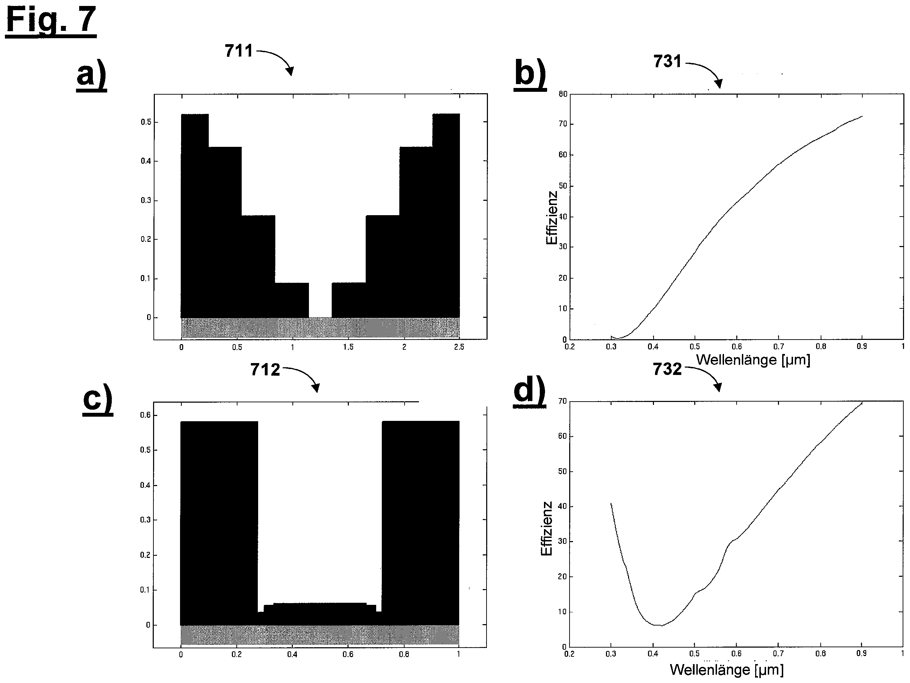

Wie im Weiteren unter Bezugnahme auf Fig. 6 und 7 erläutert wird, können auf Basis dieser jeweils simultan gemessenen Intensitätswerte auch die jeweils für die Parameterbestimmung heranzuziehenden (Hilfs-)Strukturen auf dem Wafer lokalisiert werden. Hierzu können von vorneherein in einer Datenbank einzelne typische Strukturen mit jeweils zugeordneten Intensitätsspektren abgespeichert werden, wobei ein Vergleich der anhand der tatsächlich ermittelten Intensitätsmessungen erhaltenen Spektren mit den in der betreffenden Datenbank enthaltenen Spektren jeweils die Entscheidung ermöglicht, ob in dem jeweiligen Waferbereich eine bereits bekannte bzw. identifizierte Struktur vorliegt und um welche Struktur (bzw. welche anhand dieser Struktur zu bestimmende Parameter) es sich hierbei handelt.

Wenn somit beispielsweise die Durchführung der Intensitätsmessungen mit der Anordnung gemäß Fig. 1 für zehn unterschiedliche Wellenlängen und zwei Polarisationen erfolgt und die Datenbank zwölf Paare aus jeweils einer typischen (Hilfs-)Struktur und einem jeweils zugehörigen, wellenlängenabhängigen Intensitätsspektrum umfasst, wird anhand eines Vergleichs des die 10*2 Intensitätswerte umfassenden Vektors mit den zwölf Spektren der Datenbank entschieden, ob in dem jeweiligen Waferbereich eine bereits bekannte bzw. identifizierte Struktur vorliegt und um welche Struktur (bzw. welchen anhand dieser Struktur zu bestimmenden Parameter) es sich hierbei handelt.

In Fig. 7a und Fig. 7c sind lediglich beispielhaft typische Strukturen 711 und 712 angedeutet, wobei Fig. 7b und Fig. 7d die in einer Datenbank gespeicherten, zugehörigen Spektren 731 und 732 zeigen. In Fig. 6 ist angedeutet, dass einzelne Hilfsstrukturen 621 auf einem Wafer 601 jeweils zur Bestimmung von unterschiedlichen Parametern (z.B. Overlay, Schichtdicke, CD-Wert etc.) optimiert sein können, wobei die entsprechende Identifizierung der betreffenden Hilfsstrukturen datenbankbasiert erfolgen kann (also eine vorherige Eingabe der betreffenden Information über die Position der Hilfsstrukturen auf dem Wafer entbehrlich ist).

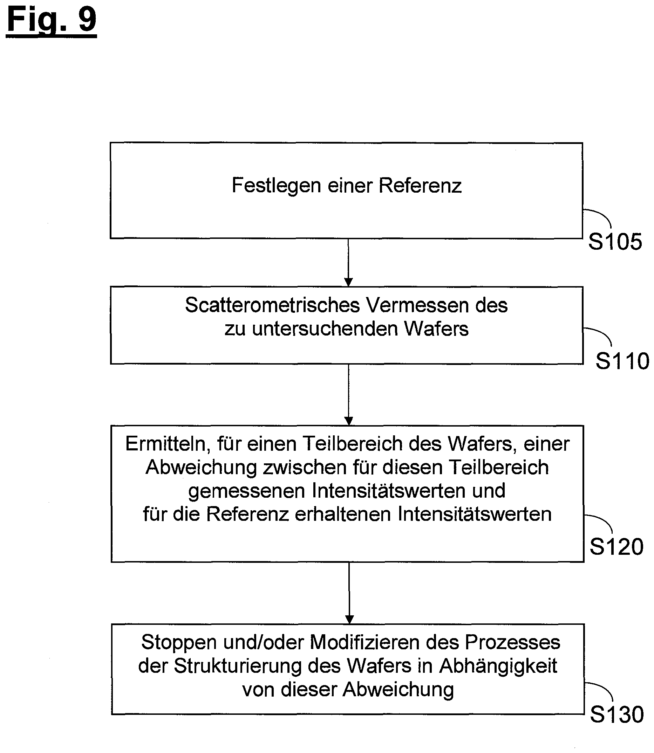

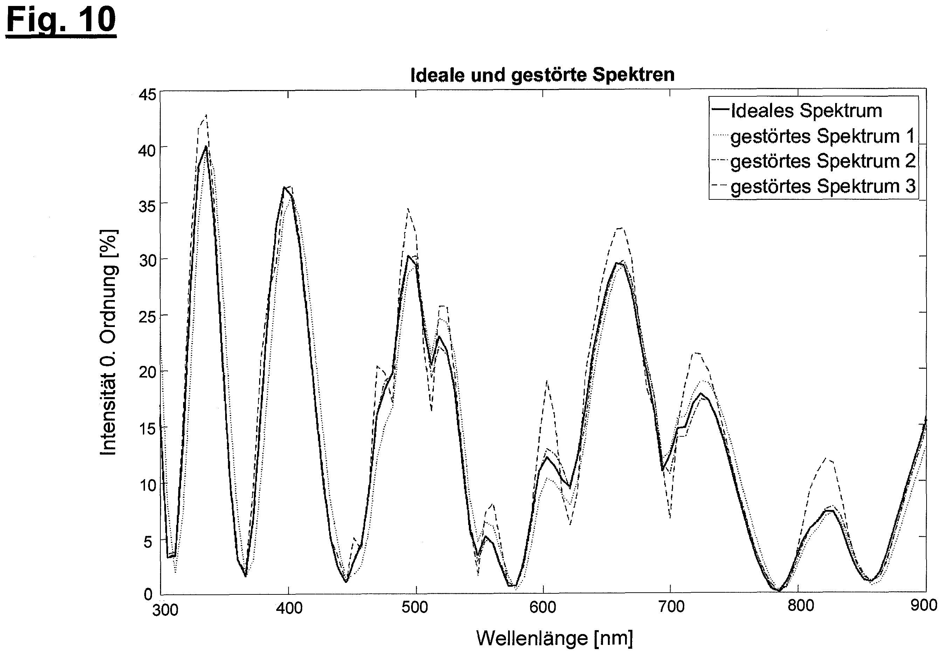

Im Weiteren werden unter Bezugnahme auf Fig. 9 und 10 nicht unter die vorliegende Erfindung fallende Verfahren beschrieben,bei denen der mit der Erstellung einer Datenbank gemäß den zuvor beschriebenen Ausführungsformen verbundene Aufwand reduziert oder sogar vollständig vermieden wird.

Gemäß diesem Verfahren wird auf bei der Waferstrukturierung auftretende Prozessvariationen und hiermit einhergehende unerwünschte Veränderungen bestimmter charakteristischer Parameter (wie z.B. der Ätztiefe) basierend darauf gefolgert, dass die auf einem Teilbereich des Wafers gemessenen Intensitätswerte bzw. Spektren mit denjenigen einer Referenz verglichen werden. Sofern dieser Vergleich eine "zu hohe Abweichung" ergibt (etwa aufgrund des Überschreitens eines in geeigneter Weise vorab festgelegten Schwellenwertes) kann dies automatisch zum Anlass genommen werden, den Prozess der Waferstrukturierung zu unterbrechen, zu stoppen oder zu modifizieren.

Die vorstehend erwähnten Teilbereiche des Wafers können insbesondere Teilbereiche außerhalb der auf dem Wafer vorhandenen periodischen, d.h. für scatterometrische Messungen zugänglichen, Nutz- sowie Hilfsstrukturen sein, wobei sich die Erfindung den Umstand zu Nutze macht, dass die für diese außerhalb der Nutz- bzw. Hilfsstrukturen befindlichen Bereiche ohnehin (aufgrund der simultan über einen größeren Bereich erfolgenden Intensitätsmessung) vorliegenden Messdaten bzw. Intensitätswerte ebenfalls (etwa aufgrund noch signifikanter Ähnlichkeiten zu den Markerbereichen) noch sinnvoll genutzt werden können. Gemäß Fig. 9 erfolgt hierzu in einem Schritt S105 zunächst das Festlegen einer geeigneten Referenz. Bei dieser Referenz kann es sich z.B. um einen Wafer handeln, für den bereits an sämtlichen Markerbereichen durchgeführte Messungen eine besonders gute Übereinstimmung mit den Nominalwerten der relevanten charakteristischen Parameter ergeben haben. Im Schritt S110 erfolgt wiederum in der üblichen, erfindungsgemäßen Weise die scatterometrische Vermessung des zu untersuchenden Wafers in Form einer Durchführung der Intensitätsmessungen für jeweils unterschiedliche Kombinationen aus Wellenlänge, Polarisation und/oder Beugungsordnung, wobei hier insbesondere auch Messdaten für einen außerhalb der periodischen Nutzsowie Markerstrukturen befindlichen Teilbereich des Wafers ermittelt werden.

In einem nachfolgenden Schritt S120 wird für den betreffenden Teilbereich des Wafers die Abweichung zwischen den dort gemessenen Intensitätswerten und den für die Referenz im entsprechenden Bereich erhaltenen Intensitätswerten ermittelt. Im Schritt S130 erfolgt ein Stoppen und/oder Modifizieren des Strukturierungsprozesses in Abhängigkeit von der Abweichung (etwa dann, wenn diese Abweichung einen geeignet gewählten Schwellenwert überschreitet). Bei einer solchen Schwellenwertüberschreitung kann dann z.B. ein entsprechender Alarm ausgelöst werden, woraufhin im Chip-Fertigungsprozess Korrekturmaßnahmen durchgeführt werden, um das betreffende Spektrum wieder möglichst in Übereinstimmung mit dem für die Referenz erhaltenen Spektrum zu bringen.

Fig. 10 zeigt hierzu eine lediglich schematische Darstellung unterschiedlicher Spektren für unterschiedliche Wafer bzw. Chips, welche zur Erzeugung grundsätzlich identischer Strukturen geringfügig voneinander abweichenden Fertigungsprozessen unterworfen werden.

Im sichtbaren Wellenlängenbereich zwischen 400nm und 700nm sind deutlich signifikante Abweichungen zwischen den Spektren erkennbar, welche auf entsprechende Prozessvariationen hinweisen und gemäß der vorstehend beschriebenen Ausführungsform als Anlass für einen Alarm bzw. für die Durchführung entsprechender Korrekturmaßnahmen genommen werden können.

Die Festlegung der entsprechenden Schwellenwerte, bei deren Überschreitung ein Alarm ausgelöst wird bzw. Korrekturmaßnahmen des Prozesses der Waferstrukturierung ausgelöst werden, kann in unterschiedlicher Weise erfolgen. Dabei sollten die jeweiligen Schwellenwerte bzw. das noch als zulässig angesehene Toleranzband so groß gewählt werden, dass auftretendes Messrauschen in jedem Falle noch toleriert wird. Konkret kann die Festlegung der jeweiligen Toleranzgrenzen dadurch erfolgen, dass zunächst zwei möglichst identische Wafer strukturiert werden, dabei einer dieser Wafer hinsichtlich der relevanten charakteristischen Parameter gezielt verändert wird (was mit anderen geeigneten Verfahren wie z.B. AFM festgestellt werden kann), wobei dann ein Vergleich der jeweils erhaltenen Spektren für diese beiden Wafer durchgeführt und als Grundlage für die Schwellenwert- bzw. Toleranzbandfestlegung verwendet werden kann.

Das vorstehend unter Bezugnahme auf Fig. 9 und Fig. 10 beschriebene Verfahren kann auch in beliebiger geeigneter Weise mit den zuvor beschriebenen Ausführungsformen kombiniert werden, wobei etwa in einzelnen Bereichen des zu untersuchenden Wafers eine datenbankbasierte Ermittlung relevanter charakteristischer Parameter erfolgt und in anderen Teilbereichen des Wafers ohne Zugriff auf irgendwelche Datenbanken die automatische Erkennung von Prozessvariationen auf Basis des vorstehend anhand von Fig. 9 und Fig. 10 beschriebenen Vergleichs mit einer Referenz erfolgt.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind und die Reichweite der Erfindung nur im Sinne der beigefügten Patentansprüche beschränkt ist.

## Patentansprüche

1. Verfahren zur Charakterisierung eines durch wenigstens einen Lithographieschritt strukturierten Wafers,
• wobei eine Mehrzahl von für den strukturierten Wafer charakteristischen Parametern auf Basis von Messungen der Intensität elektromagnetischer Strahlung nach deren Beugung an dem strukturierten Wafer ermittelt wird, wobei diese Intensitätsmessungen für wenigstens eine Nutzstruktur und wenigstens eine Hilfsstruktur durchgeführt werden;
• wobei eine Ermittlung der Parameter basierend auf bei den Intensitätsmessungen für jeweils unterschiedliche Kombinationen aus Wellenlänge, Polarisation und/oder Beugungsordnung gemessenen Intensitätswerten sowie entsprechend berechneten Intensitätswerten unter Anwendung einer mathematischen Optimierungsmethode erfolgt;
wobei die Ermittlung der für den strukturierten Wafer charakteristischen Parameter folgende Schritte aufweist:
a) Ermitteln von Parametern eines ersten Parametersatzes auf Basis der für die wenigstens eine Hilfsstruktur erhaltenen Intensitätswerte; und
b) Ermitteln von Parametern eines zweiten Parametersatzes unter Berücksichtigung der im Schritt a) ermittelten Parameter des ersten Parametersatzes;
**dadurch gekennzeichnet, dass**
die Intensitätsmessungen für die wenigstens eine Nutzstruktur und die wenigstens eine Hilfsstruktur für jeweils eine Kombination aus Wellenlänge, Polarisation und/oder Beugungsordnung simultan durchgeführt werden.

2. Verfahren nach Anspruch 1, **dadurch gekennzeichnet, dass** bei dem Schritt des Ermittelns von Parametern des zweiten Parametersatzes die im Schritt a) ermittelten Parameter des ersten Parametersatzes innerhalb eines vorgegebenen Variationsintervalls vorgegeben werden.

3. Verfahren nach Anspruch 1 oder 2, **dadurch gekennzeichnet, dass** die wenigstens eine Hilfsstruktur auf Basis einer Sensitivitätsanalyse ausgestaltet wird, bei welcher die Sensitivität unterschiedlicher Hilfsstrukturen für eine beugungsbasierte Bestimmung jeweils eines der Parameter des ersten Parametersatzes bewertet wird.

4. Verfahren nach einem der vorhergehenden Ansprüche, **dadurch gekennzeichnet, dass** die Intensitätsmessungen für eine Mehrzahl von Hilfsstrukturen durchgeführt werden, wobei diese Durchführung für jeweils eine Kombination aus Wellenlänge, Polarisation und/oder Beugungsordnung simultan erfolgt.

5. Verfahren zur Charakterisierung eines durch wenigstens einen Lithographieschritt strukturierten Wafers,
• wobei eine Mehrzahl von für den strukturierten Wafer charakteristischen Parametern auf Basis von Messungen der Intensität elektromagnetischer Strahlung nach deren Beugung an dem strukturierten Wafer ermittelt wird, wobei diese Intensitätsmessungen für wenigstens eine Nutzstruktur und wenigstens eine Hilfsstruktur durchgeführt werden;
• wobei eine Ermittlung der Parameter basierend auf bei den Intensitätsmessungen für jeweils unterschiedliche Kombinationen aus Wellenlänge, Polarisation und/oder Beugungsordnung gemessenen Intensitätswerten sowie entsprechend berechneten Intensitätswerten unter Anwendung einer mathematischen Optimierungsmethode erfolgt;
wobei die Ermittlung der für den strukturierten Wafer charakteristischen Parameter folgende Schritte aufweist:
a) Ermitteln von Parametern eines ersten Parametersatzes auf Basis der für die wenigstens eine Hilfsstruktur erhaltenen Intensitätswerte; und
b) Ermitteln von Parametern eines zweiten Parametersatzes unter Berücksichtigung der im Schritt a) ermittelten Parameter des ersten Parametersatzes;
**dadurch gekennzeichnet, dass**
die Intensitätsmessungen für eine Mehrzahl von Hilfsstrukturen durchgeführt werden, wobei diese Durchführung für jeweils eine Kombination aus Wellenlänge, Polarisation und/oder Beugungsordnung simultan erfolgt

6. Verfahren nach Anspruch 4 oder 5, **dadurch gekennzeichnet, dass** das Ermitteln von Parametern des ersten Parametersatzes auf Basis der für die Hilfsstrukturen erhaltenen Intensitätswerte einen Vergleich dieser Intensitätswerte mit in wenigstens einer Datenbank gespeicherten Intensitätswerten umfasst, wobei in dieser Datenbank mehreren Hilfsstrukturen jeweils ein zugehöriges Intensitätsspektrum zugeordnet ist.

7. Verfahren nach Anspruch 6, **dadurch gekennzeichnet, dass** auf Basis dieses Vergleichs mit in der wenigstens einen Datenbank gespeicherten Intensitätswerten eine Lokalisierung von zur Bestimmung eines Parameters jeweils geeigneten Strukturen auf dem Wafer erfolgt.

8. Verfahren nach einem der vorhergehenden Ansprüche, **dadurch gekennzeichnet, dass** die für den strukturierten Wafer charakteristischen Parameter wenigstens einen Parameter aus der Gruppe CD-Wert, Ätztiefe und Überdeckungsgenauigkeit (Overlay) von zwei in unterschiedlichen Lithographieschritten erzeugten Strukturen umfassen.

9. Vorrichtung zur Charakterisierung eines durch wenigstens einen Lithographieschritt strukturierten Wafers, **dadurch gekennzeichnet, dass** die Vorrichtung dazu konfiguriert ist, ein Verfahren nach einem der vorhergehenden Ansprüche durchzuführen.

## Claims

1. Method for characterizing a wafer patterned using at least one lithography step,
• wherein a plurality of parameters characteristic of the patterned wafer are ascertained on the basis of measurements of the intensity of electromagnetic radiation after the diffraction thereof at the patterned wafer, wherein these intensity measurements are carried out for at least one used structure and at least one auxiliary structure;
• wherein the parameters are ascertained on the basis of intensity values measured during the intensity measurements for respectively different combinations of wavelength, polarization and/or order of diffraction, and also on the basis of correspondingly calculated intensity values, with a mathematical optimization method being applied;
wherein the ascertainment of the parameters characteristic of the patterned wafer includes the following steps:
a) ascertaining parameters of a first parameter set on the basis of the intensity values obtained for the at least one auxiliary structure; and
b) ascertaining parameters of a second parameter set taking account of the parameters of the first parameter set ascertained in step a),
**characterized in that**
the intensity measurements are carried out simultaneously for the at least one used structure and the at least one auxiliary structure for a respective combination of wavelength, polarization and/or order of diffraction.

2. Method according to Claim 1, **characterized in that** the step of ascertaining parameters of the second parameter set involves predefining the parameters of the first parameter set ascertained in step a) within a predefined variation interval.

3. Method according to Claim 1 or 2, **characterized in that** the at least one auxiliary structure is configured on the basis of a sensitivity analysis, in which the sensitivity of different auxiliary structures is assessed for a diffraction-based determination of a respective one of the parameters of the first parameter set.

4. Method according to one of the preceding claims, **characterized in that** the intensity measurements are carried out for a plurality of auxiliary structures, wherein the intensity measurements are carried out simultaneously for a respective combination of wavelength, polarization and/or order of diffraction.

5. Method for characterizing a wafer patterned using at least one lithography step,
• wherein a plurality of parameters characteristic of the patterned wafer are ascertained on the basis of measurements of the intensity of electromagnetic radiation after the diffraction thereof at the patterned wafer, wherein these intensity measurements are carried out for at least one used structure and at least one auxiliary structure;
• wherein the parameters are ascertained on the basis of intensity values measured during the intensity measurements for respectively different combinations of wavelength, polarization and/or order of diffraction, and also on the basis of correspondingly calculated intensity values, with a mathematical optimization method being applied;
wherein the ascertainment of the parameters characteristic of the patterned wafer includes:
a) ascertaining parameters of a first parameter set on the basis of the intensity values obtained for the at least one auxiliary structure; and
b) ascertaining parameters of a second parameter set taking account of the parameters of the first parameter set ascertained in step a),
**characterized in that**
the intensity measurements are carried out for a plurality of auxiliary structures, wherein these intensity measurements are carried out simultaneously for a respective combination of wavelength, polarization and/or order of diffraction.

6. Method according to Claim 4 or 5, **characterized in that** the ascertainment of parameters of the first parameter set on the basis of the intensity values obtained for the auxiliary structures comprises a comparison of these intensity values with intensity values stored in at least one database, wherein in said database an associated intensity spectrum is respectively assigned to a plurality of auxiliary structures.

7. Method according to Claim 6, **characterized in that** a localization of structures respectively suitable for determining a parameter on the wafer is effected on the basis of said comparison with intensity values stored in the at least one database.

8. Method according to one of the preceding claims, **characterized in that** the parameters characteristic of the patterned wafer comprise at least one parameter from the group CD value, etching depth and overlay accuracy of two structures produced in different lithography steps.

9. Apparatus for characterizing a wafer patterned using at least one lithography step, **characterized in that** the apparatus is configured to carry out a method according to one of the preceding claims.

## Revendications

1. Procédé de caractérisation d'une tranche structurée par au moins une étape de lithographie,
- dans lequel une pluralité de paramètres caractéristiques pour la tranche structurée sont déterminés sur la base de mesures de l'intensité d'un rayonnement électromagnétique après diffraction de celui-ci sur la tranche structurée, dans lequel ces mesures d'intensité sont mises en œuvre pour au moins une structure utile et au moins une structure auxiliaire ;
- dans lequel une détermination des paramètres s'effectue en se basant sur des valeurs d'intensité mesurées pour des combinaisons différentes de longueur d'onde, de polarisation et/ou d'ordre de diffraction lors des mesures d'intensité ainsi que sur des valeurs d'intensité calculées de manière correspondante par application d'une méthode d'optimisation mathématique ; dans lequel la détermination des paramètres caractéristiques pour la tranche structurée comporte les étapes suivantes :
a) détermination des paramètres d'un premier jeu de paramètres sur la base des valeurs d'intensité obtenues pour l'au moins une structure auxiliaire ; et
b) détermination des paramètres d'un premier jeu de paramètres en prenant en compte les paramètres du premier jeu déterminés à l'étape a) ;
**caractérisé en ce que**
les mesures d'intensité pour l'au moins une structure utile et l'au moins une structure auxiliaire sont mises en œuvre simultanément pour une combinaison respective de longueur d'onde, de polarisation et/ou d'ordre de diffraction.

2. Procédé selon la revendication 1, **caractérisé en ce que** lors de l'étape de la détermination des paramètres du deuxième jeu de paramètres, les paramètres du premier jeu de paramètres déterminés à l'étape a) sont prédéfinis à l'intérieur d'un intervalle de variation prédéfini.

3. Procédé selon la revendication 1 ou 2, **caractérisé en ce que** l'au moins une structure auxiliaire est configurée sur la base d'une analyse de sensibilité, lors de laquelle la sensibilité de différentes structures auxiliaires est mesurée pour une détermination respective, basée sur la diffraction, d'un des paramètres du premier jeu de paramètres.

4. Procédé selon l'une des revendications précédentes, **caractérisé en ce que** les mesures d'intensité sont mises en œuvre pour une pluralité de structures auxiliaires, dans lequel cette mise en œuvre s'effectue simultanément pour une combinaison respective de longueur d'onde, de polarisation et/ou d'ordre de diffraction.

5. Procédé de caractérisation d'une tranche structurée par au moins une étape de lithographie,
- dans lequel une pluralité de paramètres caractéristiques pour la tranche structurée sont déterminés sur la base de mesures de l'intensité d'un rayonnement électromagnétique après diffraction de celui-ci sur la tranche structurée, dans lequel ces mesures d'intensité sont effectuées pour au moins une structure active et au moins une structure auxiliaire ;
- dans lequel une détermination des paramètres s'effectue en se basant sur des valeurs d'intensité mesurées pour des combinaisons différentes de longueur d'onde, de polarisation et/ou d'ordre de diffraction lors des mesures d'intensité ainsi que des valeurs d'intensité calculées de manière correspondante par application d'une méthode d'optimisation mathématique ;
dans lequel la détermination des paramètres caractéristiques pour la tranche structurée comporte les étapes suivantes :
a) détermination des paramètres d'un premier jeu de paramètres sur la base des valeurs d'intensité obtenues pour l'au moins une structure auxiliaire ; et
b) détermination des paramètres d'un premier jeu de paramètres en prenant en compte les paramètres du premier jeu déterminés à l'étape a) ;
**caractérisé en ce que**
les mesures d'intensité sont mises en œuvre pour une pluralité de structures auxiliaires, dans lequel cette mise en œuvre s'effectue simultanément pour une combinaison respective de longueur d'onde, de polarisation et/ou d'ordre de diffraction.

6. Procédé selon la revendication 4 ou 5, **caractérisé en ce que** la détermination des paramètres du premier jeu de paramètres sur la base des valeurs d'intensité obtenues pour les structures auxiliaires comprend une comparaison de ces valeurs d'intensité avec des valeurs d'intensité mémorisées dans au moins une base de données, dans lequel un spectre d'intensité est respectivement associé à chacune de plusieurs structures auxiliaires dans cette base de données.

7. Procédé selon la revendication 6, **caractérisé en ce que** sur la base de cette comparaison avec les valeurs d'intensité mémorisées dans l'au moins une base de données s'effectue sur la tranche une localisation de structures respectivement adaptées à la détermination d'un paramètre.

8. Procédé selon l'une des revendications précédentes, **caractérisé en ce que** les paramètres caractéristiques de la tranche comprennent au moins un paramètre issu du groupe constitué par la valeur de dimension critique (CD), la profondeur de gravure et la précision de chevauchement (overlay) de deux structures générées à des étapes de lithographie différentes.

9. Dispositif de caractérisation d'une tranche structurée par au moins une étape de lithographie, **caractérisé en ce que** le dispositif est configuré pour mettre en œuvre un procédé selon l'une des revendications précédentes.
